# EUROPEAN PATENT APPLICATION

(11) **EP 0 945 897 A1**
(43) Date of publication of application: **29.09.1999**
(21) Application number: 99200586.8
(22) Date of filing: 02.03.1999
(51) Int. Cl.: H01L 21/312, H01L 21/8238, H01L 21/28, H01L 21/336

(54) **Organic gate sidewall spacers**

(30) Priority: 25.03.1998 US 79236 P
(71) Applicant: TEXAS INSTRUMENTS INCORPORATED, Dallas, TX 75265 (US)
(72) Inventor: Joyner, Keith A., Richardson, Texas 75081 (US)
(74) Representative: Holt, Michael

(57) **Abstract**

Integrated circuit fabrication methods in which a disposable spacer (232) is formed of an organic material, such as parylene, in self-alignment to the sidewall of a gate structure. For example, this is useful for drain profile engineering, since a heavy implant can be spaced farther from the gate corner than the width of the normal sidewall spacer.

## Description

### Background and Summary of the Invention

The present invention relates to integrated circuit fabrication methods, and particularly to the use of disposable sidewall spacers in integrated circuit fabrication.

### Background: Scaling

A continuing trend in integrated circuit device technology has been the steady shrinkage of device dimensions, which has proceeded on a fairly steady exponential curve for many years. With conventional MOS technology, as the minimum patterned dimension (the "critical dimension") shrinks, the gate oxide becomes thinner, the diffusions become shallower, and the transistor minimum channel length becomes smaller. Commonly the supply voltage is also reduced. Further details regarding conventional scaling strategies can be found, for example, in Voorde, "MOSFET scaling into the future," Hewlett-Packard Journal, vol.48, no.4, pp.96-100 (Aug. 1997), which is hereby incorporated by reference.

### Background: Drain Profile Engineering

One of the long-standing problems in submicron field effect transistors is hot carrier effects. In an old-fashioned NMOS single-drain-diffusion transistor structure, the potential energy (voltage) of an electron changes dramatically as it crosses the boundary of the N+ drain diffusion. This sharp change in potential energy, over a short distance, defines a high electric field value. The high electron-field value causes the electrons to behave in a different way (as "hot" electrons) within the semiconductor lattice. Such electrons can, for example, penetrate into or through the gate dielectric, and can cause the gate dielectrics to become charged up over time, causing the transistor to fail in service.

Another effect which is of concern in higher-voltage devices is avalanche breakdown. Again, higher peak electric field values will tend to cause avalanching to begin at lower voltages.

To avoid these effects, several techniques have been proposed. One of these techniques is lightly doped drain extension (LDD) regions, in which sidewall spacers are used as an aid to drain profiling. A first light, shallow implant is performed before sidewall spacers are formed on the gate structure, with a second heavier implant performed after spacers are formed. In modern processes, as LDD implants have reached higher dosages, they are sometimes referred to as medium-doped drain (MDD) implants.

Current processes may use three, or sometimes four, separate implants to optimize the drain profile. This provides further smoothness in the gradation of the voltage as seen by a carrier passing through the channel into the drain, and thereby reduces the peak electric field.

### Background: Structural Elements in Etching or Implantation

In a number of applications in semiconductor processing, structural elements are used to control etching or the deposition of dopants. Photoresist is also used to mask or control etches or depositions. However, since existing structural elements are deposited at high temperature, their deposition is incompatible with the presence of photoresist. For example, implantation of the LDD, MDD, and source/drain implants normally uses photoresist to block dopants from the opposite transistor type, and uses oxide (e.g. TEOS) or nitride (e.g. LPCVD) sidewall spacers to space the dopant away from the gate edge. Since at least one energy dosage is desired next to the gate (for the LDD or MDD) and another further away from the gate (for source/drain), at least two masking operations are required for each transistor type.

### Summary: Ashable Gate Sidewall Spacer

The present invention describes a new modification in integrated circuit processing, wherein disposable sidewall spacers on gate lines are formed of organic materials, such as parylene and plasma polymers. These spacers are preferably used in combination with inorganic (and permanent) sidewall spacers, but since the disposable spacers are deposited by low-temperature processes, it is possible to use them with photoresist in place, providing an additional degree of freedom in defining optimal source/drain diffusion profiling. Another particular advantage is that ashing to remove the organic sidewall spacers is not only a fairly benign process, but also one which must be performed in any case to remove photo-resist after patterning steps.

Advantages of the disclosed methods and structures include:
- can be used while resist is in place;
- fewer masking steps needed;
- eliminates rapid thermal anneals (RTAs) and associated cleanups;
- eliminates a long, intermediate temperature nitride deposition;
- spacers are removed without additional steps;
- provides new degrees of freedom for pattern adjustment, including more flexibility in decoupling NMOS vs. PMOS processes;
- provides more flexible self-alignment relations;
- reduced process complexity;
- reduces the thermal budget substantially; and
- reduces cost of fabrication.

### Brief Description of the Drawings

The disclosed inventions will be described with reference to the accompanying drawings, which show important sample embodiments of the invention and which are incorporated in the specification hereof by reference, wherein:

Figure 1 shows a flowchart of one embodiment of a CMOS process which utilizes the disclosed organic gate sidewall spacers.

Figures 2A-2I show cross-sections of a CMOS device during fabrication of one disclosed class of embodiments.

### Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. In general, statements made in the specification of the present application do not necessarily delimit any of the various claimed inventions. Moreover, some statements may apply to some inventive features but not to others.

### Overview of Process

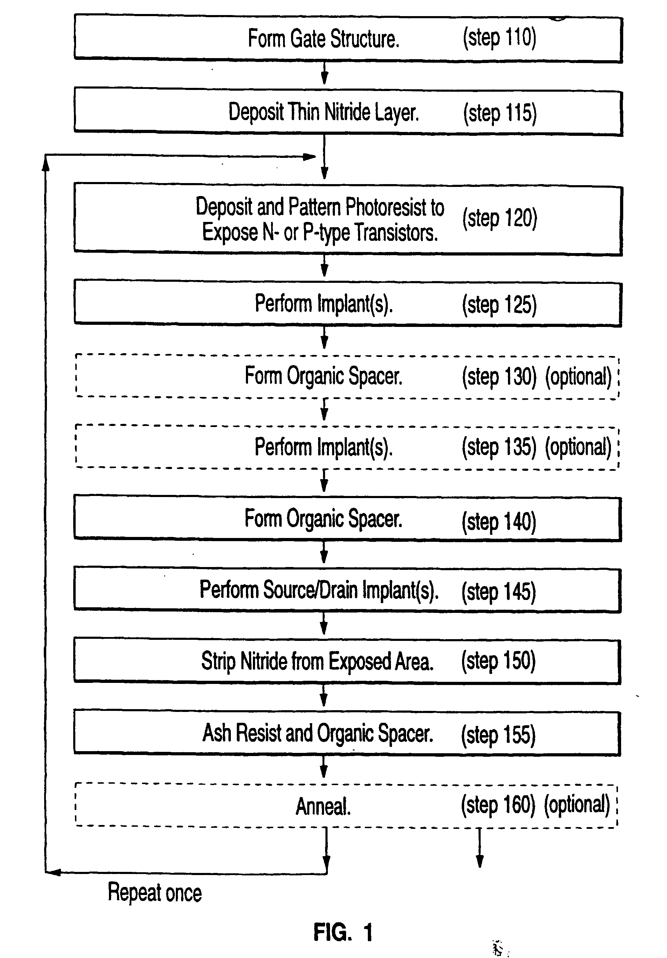

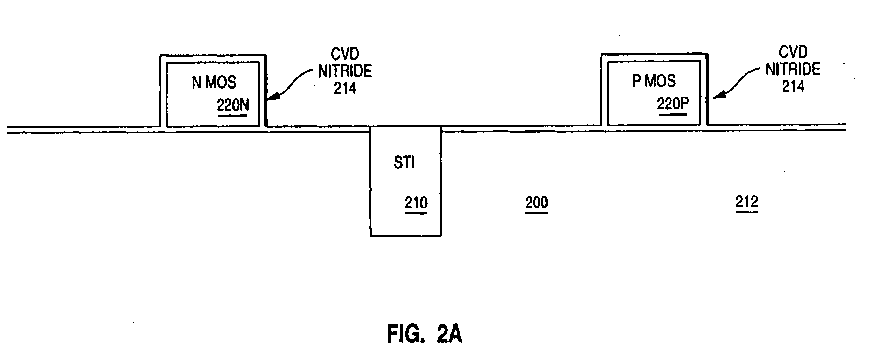

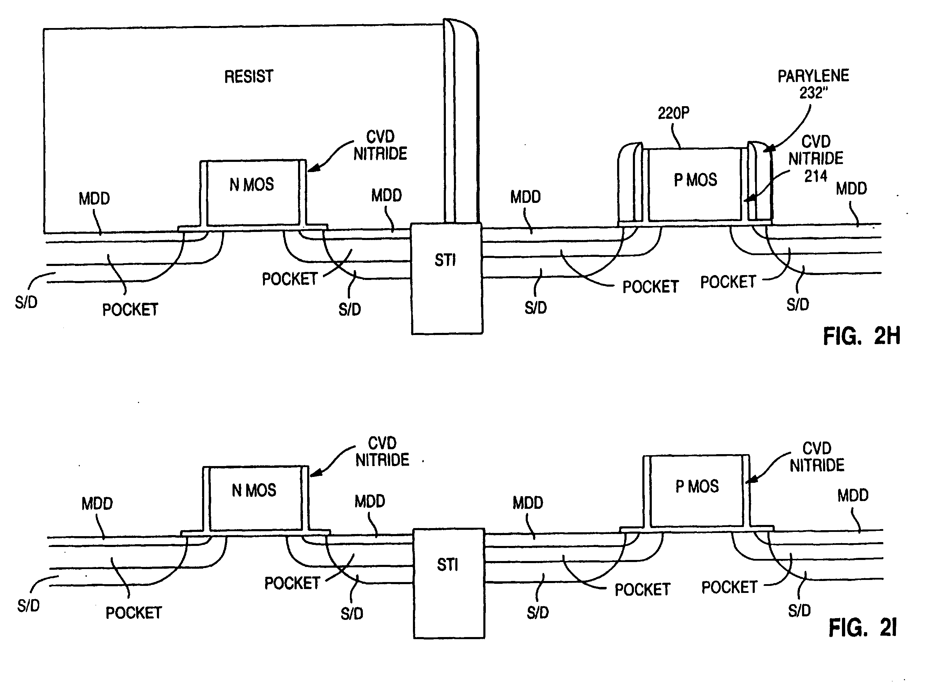

Figure 1 shows a partial process flow for fabrication of a CMOS structure, using the disclosed organic sidewall spacers. This will now be discussed with reference to Figures 2A-2I, which show cross-sections of the wafer at various points in the fabrication process. Prior to the flow shown in Figure 1, isolation structures 210 and a gate oxide 212 will have been formed. In Figure 2A, the process begins with the formation (step 110) of gate structures 220N and 220P, which are preferably formed from a single conductive layer, but they can optionally be formed from two or more separately deposited and patterned conductive layers, if desired for work function or dielectric optimization. A smiling oxidation (not shown) is generally performed, and a thin layer of CVD nitride 214, about 200 nm thick, is deposited (step 115). It is noted that in the drawings, over the areas which will become the source/drain areas, gate oxide layer 212 and nitride layer 214 are shown as a single layer because of their thinness.

Steps 120-160 of Figure 1 are performed once to implant the N-type transistors, and again to implant the P-type transistors. These can be done in either order, but the following discussion presume that the N-type transistors are implanted first.

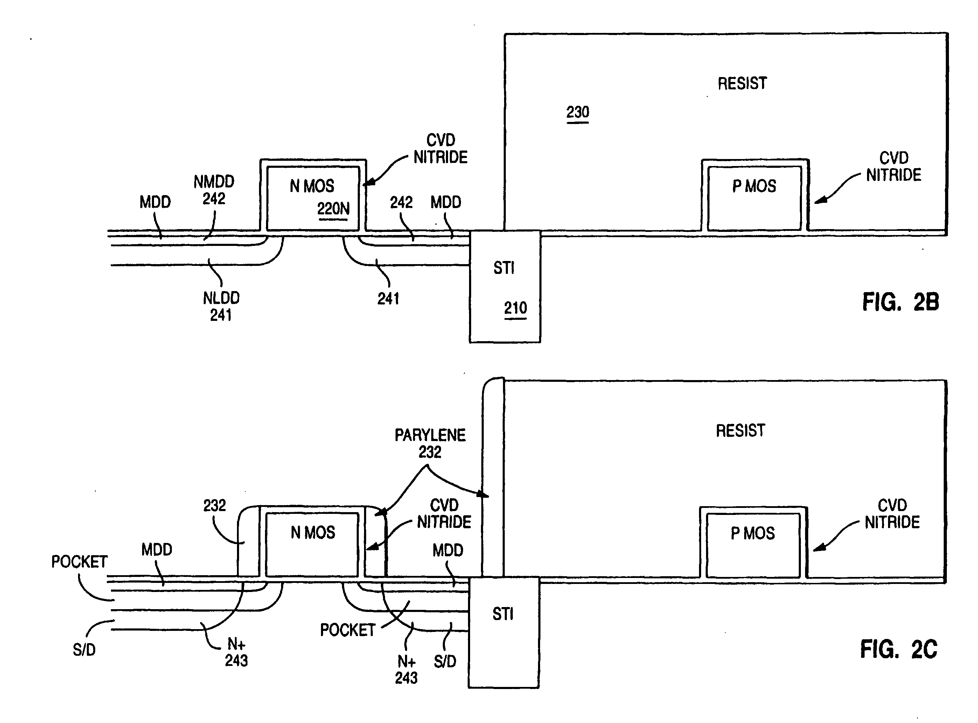

As shown in Figure 2B, photoresist 230 is deposited and patterned (step 120) to expose only the N-type transistors. A "pocket" implant and MDD implant of the N-type transistors are performed (step 125), forming regions 241 and 242 in the example shown.

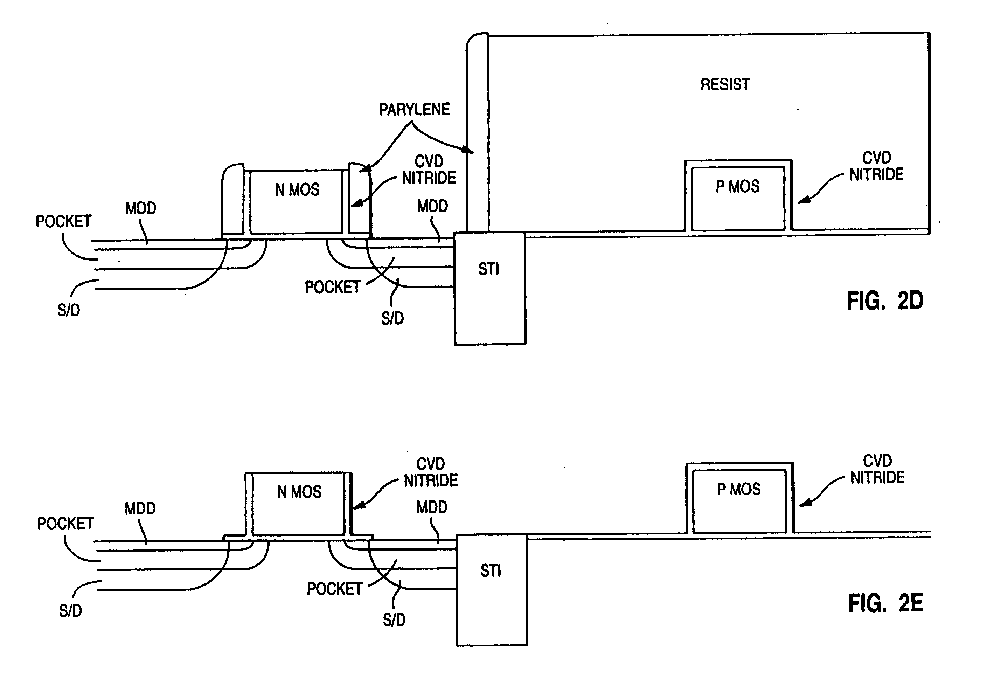

In Figure 2C, an organic sidewall spacer 232 is formed on the exposed gate structures of the N-type transistors (step 140), and on the edges of the photoresist also. Once the spacer is formed, source/drain regions 243 are implanted (step 145). The thin nitride layer 214 is then stripped (step 150) from the exposed NMOS active area (see Figure 2D), followed by an ashing or chemical stripping (step 155) of the resist 230 and organic spacer 232, shown in Figure 2E. This completes the implantation steps for the NMOS transistors, and steps 130-165 will be repeated for the PMOS transistors.

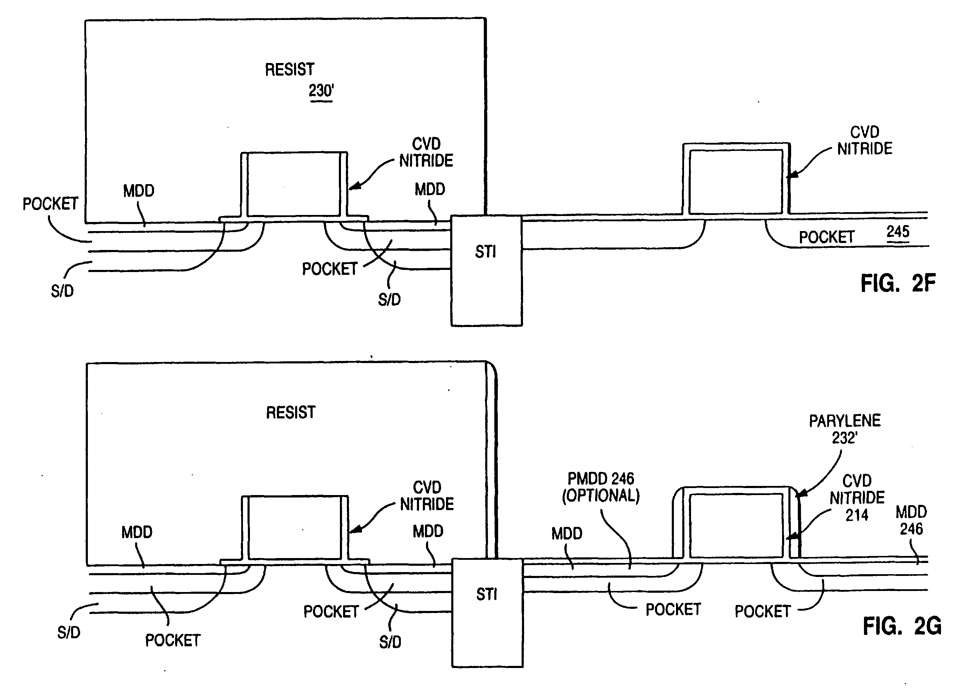

Looking now at Figure 2F, a new layer of photoresist 230• is deposited and patterned (step 120) to exposed only the P-type transistors, followed by implantation (step 125) of the P-type "pocket" areas 245. In Figure 2G, optional organic sidewall spacer 232• is formed (step 130), followed by the optional MDD implantation (step 135) to form region 246. This is followed, in Figure 2H, by formation of organic sidewall spacer 232•, which allow proper source/drain separation (step 140) and implantation (step 145) of the P-type source/drain areas 248. Finally, as seen in Figure 2I, the nitride 214 is removed from the P-type transistor's exposed active areas (step 150) and the resist 230• and organic spacers 232• and 232• are ashed or chemically stripped (step 155). Optionally, an anneal can be performed (step 160) to disperse the dopants. At this point, normal processing is resumed for the integrated circuit.

Note that since spacers for the NMOS transistors are formed separately from those for the PMOS transistors, each transistor type can be separately optimized in both number of doping levels and separation between various implantations.

### First Embodiment: Parylene

In a first embodiment, parylene, and optionally adhesion promoters, are deposited and anisotropically etched with 02 to form disposable spacers. Parylene will typically be deposited to a thickness of 10-100 nm. This organic material has high conformality and can be easily ashed along with the photoresist, using e.g. 02 and 5 percent of CF4 in a microwave afterglow asher, or alternate chemistries shown below.

### Second Embodiment: Plasma Deposited Hydrocarbon

A group of organic materials which may fit the requirements for conformality and ashability are plasma deposited hydrocarbons. Deposited thickness of the specific hydrocarbon used would depend on the conformality of that material, with the thickness being in the same range as parylene if the conformality was similar. These materials are more difficult to ash than parylene, but are still expected to be ashable.

### Alternate Embodiment: Inorganic Spacer after Organic

In one class of embodiments, a disposable organic spacer is first used to mask the source/drain implantation from the area nearest the gates; after implantation, the organic spacer is removed and replaced by a permanent inorganic spacer. In this embodiment, the use of spacers for implantation masking and for the limitation of silicide growth can be separately optimized.

According to a disclosed class of innovative embodiments, there is provided: An integrated circuit processing method, comprising the steps of: forming an organic structure which is self-aligned to an edge of a gate structure; performing a processing operation which is at least partially controlled by the position of said organic structure; and removing said organic structure.

According to another disclosed class of innovative embodiments, there is provided: A method for forming a transistor gate structure, comprising the steps of: forming, over a semiconductor material, a patterned gate conductor layer having sidewalls; and forming a first sidewall spacer in a self-aligned relationship to said sidewalls of said gate conductor; forming a second sidewall spacer, of an organic material, in a self-aligned relationship to said sidewalls of said gate conductor; and introducing dopants into said semiconductor material, as masked by said first sidewall spacer and/or said second sidewall spacer and thereafter removing said second sidewall spacer.

### Modifications and Variations

As will be recognized by those skilled in the art, the innovative concepts described in the present application can be modified and varied over a tremendous range of applications, and accordingly the scope of patented subject matter is not limited by any of the specific exemplary teachings given, but is only defined by the issued claims.

In an alternate embodiment, after the organic sidewall is removed, an inorganic sidewall is then deposited. Optionally, at this time, a further implant can be performed, and this can optionally be the main source/drain implant. The metal deposition step for silicide cladding is preferably formed after this final inorganic spacer is formed, but optionally can be formed after the organic spacer is removed (although this is less preferable).

In an alternate embodiment, parylene can be ashed using a chemistry of 02 and about 5% N2 or Ar.

In an alternate embodiment, organic materials which can be deposited from a fluid source can be deposited by gas or liquid phase deposition to create the disposable spacers. A fluid is believed necessary for reasonable isotropy of deposition.

## Claims

1. An integrated circuit processing method, comprising the steps of:
forming an organic structure which is self-aligned to an edge of a gate structure;
performing a processing operation which is at least partially controlled by the position of said organic structure; and removing said organic structure.

2. The method of Claim 1, wherein said organic structure primarily comprises parylene.

3. The method of Claim 1, wherein said organic structure primarily comprises plasma deposited hydrocarbons.

4. The method of Claim 1, wherein said organic structure is deposited from a fluid.

5. A method for forming a transistor gate structure, comprising the steps of:
forming, over a semiconductor material, a patterned gate conductor layer having sidewalls; and
forming a first sidewall spacer in a self-aligned relationship to said sidewalls of said gate conductor;
forming a second sidewall spacer, of an organic material, in a self-aligned relationship to said sidewalls of said gate conductor; and
introducing dopants into said semiconductor material, as masked by said first sidewall spacer and/or said second sidewall spacer and thereafter removing said second sidewall spacer.

6. The method of Claim 5, wherein said second sidewall spacer primarily comprises parylene.
